# EUROPEAN PATENT SPECIFICATION

(11) **EP 2 259 362 B1**
(45) Date of publication and mention of the grant of the patent: **10.10.2012**
(21) Application number: 10164572.9
(22) Date of filing: 01.06.2010
(51) Int. Cl.: H01L 51/52

(54) **Organic light emitting diode**
Organische lichtemittierende Diode
Diode électroluminescente organique

(30) Priority: 01.06.2009 KR 20090048241
(43) Date of publication of application: 08.12.2010
(73) Proprietor: Samsung Display Co., Ltd., Yongin-City, Gyeonggi-Do, 446-711 (KR)
(72) Inventor: Im, Choong-Youl, 446-711, Gyunggi-Do (KR); Yoo, Kyung-Jin, 446-711, Gyunggi-Do (KR); Yu, Cheol-Ho, 446-711, Gyunggi-Do (KR)
(74) Representative: Gulde Hengelhaupt Ziebig & Schneider

(56) References cited:
- WO-A1-99/39393
- WO-A1-03/055275
- JP-A- 2008 122 941
- US-A1- 2009 134 393

## Description

### BACKGROUND OF THE INVENTION

### Field of the Invention

The present invention relates to an organic light emitting diode (OLED), and more particularly, to an OLED including a first electrode including an aluminum (Al)-based reflective film and a transparent conductive film. The OLED has excellent thermal stability, light efficiency, and durability.

### Description of the Related Art

Organic light emitting diodes (OLEDs), which are self-emitting type devices, have a wide viewing angle, excellent contrast, rapid response time, excellent brightness, excellent driving voltage, and high response speed, and may realize multicolored images.

A general OLED may have a structure in which an anode, a hole transfer layer (HTL), an emitting layer (EML), an electron transfer layer (ETL), and a cathode are sequentially formed on a substrate. The HTL, the EML, and the ETL are organic thin films formed of an organic compound.

An operating principle of the OLED having the structure described above is as follows. When a voltage is applied between the anode and the cathode, holes injected from the anode pass through the HTL and reach the EML and electrons injected from the cathode pass through the ETL and reach the EML. The holes and electrons are recombined with each other in the EML and excitons are generated. A state of the excitons is changed from an excited state to a ground state and thus light is emitted.

JP2008122941 A discloses a reflective electrode used in a LCD display comprising: an aluminum-nickel alloy and at least one element selected from contains element chosen from lanthanum, magnesium, chromium, manganese, ruthenium, rhodium, platinum, palladium, iridium, cerium, praseodymium, gadolinium, terbium, dysprosium, neodymium, titanium, zirconium, niobium, molybdenum, hafnium, tantalum, tungsten, yttrium, iron, cobalt, samarium, europium, holmium, erbium, thulium, ytterbium and lutetium, and a transparent conductive film.

WO99/39393 A discloses an OLED with an anode comprising a light transmitting stack of metal layer, barrier layer and an anode modification layer contacting the organic layer. The modification layer may be a deposited layer or an oxidized portion of the barrier layer. A preferable structure is metal /Ni/NiO_{X}/V₂0₅ anode.

WO03/055275 A discloses an OLED comprising a first electrode having a conductive layer; a buffer layer formed on the conductive layer; a nonmetal layer formed on the buffer layer; a fluorocarbon layer formed on the nonmetal layer. A preferable anode arrangement is Al/Ni/NiOₓ/CFₓ.

### SUMMARY OF THE INVENTION

The present invention refers to an organic light emitting diode (OLED) including an electrode including an aluminum (Al)-based reflective film and a transparent conductive film, wherein the OLED has excellent thermal stability, light efficiency, and durability.

According to the present invention, an organic light emitting diode (OLED) includes a substrate; a first electrode formed on the substrate; a second electrode disposed on the first electrode; and an organic layer interposed between the first electrode and the second electrode. The first electrode comprises an aluminum (Al)-based reflective film including nickel (Ni) and at least one rare earth metal selected from the group consisting of lanthanum (La), cerium (Ce), praseodymium (Pr), promethium (Pm), samarium (Sm), europium (Eu), gadolinium (Gd), terbium (Tb), dysprosium (Dy), holmium (Ho), erbium (Er), thulium (Tm) and lutetium (Lu); and a transparent conductive film interposed between the Al-based reflective film (5a) and the organic layer.

The first electrode further comprises a Ni rich oxide layer interposed between the Al-based reflective film and the transparent conductive film.

The Al-based reflective film may include grains of an intermetallic phase consisting of AlₓNi, where x is in the range of 2.5 to 3.5. The grains may contact the transparent conductive film. The intermetallic phase may consist of Al₃Ni.

The first electrode may further include a Ni rich oxide layer interposed between the the Al-based reflective film and the transparent conductive film.

The amount of Ni in the Al-based reflective film may be in the range of 0.6 weight % to 5 weight %.

The rare earth metal may be lanthanum (La).

The amount of the rare earth metal may be 0.1 weight % to 3 weight %.

Thickness of the Al-based reflective film may be 50 nm or greater.

The transparent conductive film may be one selected from the group consisting of indium tin oxide (ITO), indium zinc oxide (IZO), tin oxide (SnO₂), and zinc oxide (ZnO).

The thickness of the transparent conductive film may be 5 nm to 100 nm.

The first electrode may further include a metal layer. The metal layer may be formed between the Al-based reflective film and the substrate.

The metal layer may include at least one metal selected from the group consisting of molybdenum (Mo), tungsten (W), titanium (Ti), palladium (Pd), platinum (Pt), and gold (Au).

The organic layer may include an emitting layer (EML) ant optionally at least one selected from the group consisting of a hole injection layer (HIL), a hole transfer layer (HTL), a hole blocking layer (HBL), an electron transfer layer (ETL), and an electron injection layer (EIL).

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIG. 1 is a cross-sectional diagram of an organic light emitting diode (OLED) according to an embodiment of the present invention;

FIG. 2A is a cross-sectional transmission electron microscope (TEM) image of an aluminum (Al)-based reflective film according to an embodiment of the present invention;

FIG. 2B shows a scanning transmission electron microscope (STEM) high-angle annular dark-filed (HAADF) image of the aluminum (Al)-based reflective film;

FIG. 2C shows graphs showing a result of analyzing components of abnormal grown grains of the aluminum (Al)-based reflective film of FIG. 2A;

FIG. 3 is a photographic image of a cross-section of a first electrode according to another embodiment of the present invention;

FIG. 4A is a photographic image of an image of an OLED observed with the naked eye according to an embodiment of the present invention;

FIG. 4B is a microscopic image of a part of the image of FIG. 4A that is indicated by a dashed rectangle F; and

FIG. 5 is a cross-sectional diagram of an OLED according to another embodiment of the present invention.

### DETAILED DESCRIPTION OF THE INVENTION

Reference will now be made in detail to embodiments, examples of which are illustrated in the accompanying drawings, wherein like reference numerals refer to the like elements throughout.

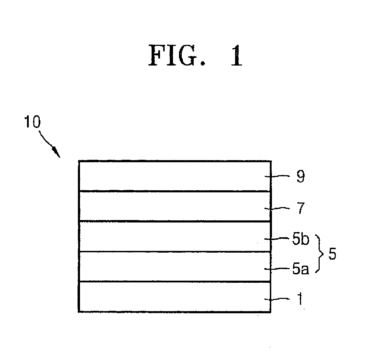

FIG. 1 is a cross-sectional diagram of an organic light emitting diode (OLED) 10 according to an embodiment of the present invention. Referring to FIG. 1, the OLED 10 according to the present embodiment has a structure in which a first electrode 5, an organic layer 7, and a second electrode 9 are sequentially formed in this order on a substrate 1. The first electrode 5 includes an aluminum (Al)-based reflective film 5a including a first element and nickel (Ni) and a transparent conductive film 5b. The Al-based reflective film 5a is disposed to be closer to the substrate 1 than the transparent conductive film 5b and contacts the transparent conductive film 5b.

The substrate 1 may be any substrate that is used in a general OLED and may be a glass substrate or a transparent plastic substrate having excellent mechanical strength, thermal stability, transparency, surface smoothness, tractability, and waterproofness.

The Al-based reflective film 5a includes aluminum (Al), a rare earth metal and nickel (Ni), and is formed on the substrate 1. The rare earth metal may be at least one selected from the group consisting of lanthanum (La), cerium (Ce), praseodymium (Pr), promethium (Pm), samarium (Sm), europium (Eu), gadolinium (Gd), terbium (Tb), dysprosium (Dy), holmium (Ho), erbium (Er), thulium (Tm), and lutetium (Lu). Preferably, the rare earth metal is lanthanum (La).

The Al-based reflective film 5a has high reflectivity and thus the OLED 10 may have excellent light efficiency. Also, the Al-based reflective film 5a has high thermal stability based on the properties of Al so that durability thereof is excellent even if the Al-based reflective film 5a is exposed to a high-temperature manufacturing process. In addition, the Al-based reflective film 5a has excellent adhesive properties with an inorganic layer or an organic layer.

The transparent conductive film 5b is disposed on the Al-based reflective film 5a and contacts the Al-based reflective film 5a. However, galvanic corrosion, which occurs due to a potential difference of electrodes, not occurs between the Al-based reflective film 5a and the transparent conductive film 5b.

Galvanic corrosion is an electrochemical process whereby a voltage is generated due to a potential difference between two different metals in electrical contact with each other, current flows, and electricity is generated. As such, the metal with greater activity (low potential) due to a difference in work function at the interface between the two metals acts as the anode and the metal with relatively low activity (high potential) acts as the cathode. When the two metals are exposed to a corrosive solution and corrosion is generated in the two metals due to the potential difference between the two metals, galvanic corrosion occurs. The anode, having greater activity, is quickly corroded and the cathode, having low activity, is slowly corroded. When the galvanic corrosion spreads along the interface between two electrode layers respectively formed of the different metals, contact resistance between the electrode layers is rapidly increased and unstable resistance dispersion may result. Accordingly, when an OLED having such electrode layers is driven, the colors of some pixel become more bright and the colors of other pixels become less bright, resulting in non-uniformity of brightness over the pixels. As a result, image quality may be poor. Thus, galvanic corrosion may be a factor that decreases the quality of OLEDs.

However, because the Al-based reflective film 5a includes the rare earth metal galvanic corrosion is not initiated between the Al-based reflective film 5a and the transparent conductive film 5b. Accordingly, the OLED according to the present embodiment maintains high image quality over time.

The Al-based reflective film 5a includes Ni. As a result, the Al-based reflective film 5a may include grains of AlₓNi as an intermetallic phase (here, x represents atom % of Al and is in the range of 2.5 to 3.5).

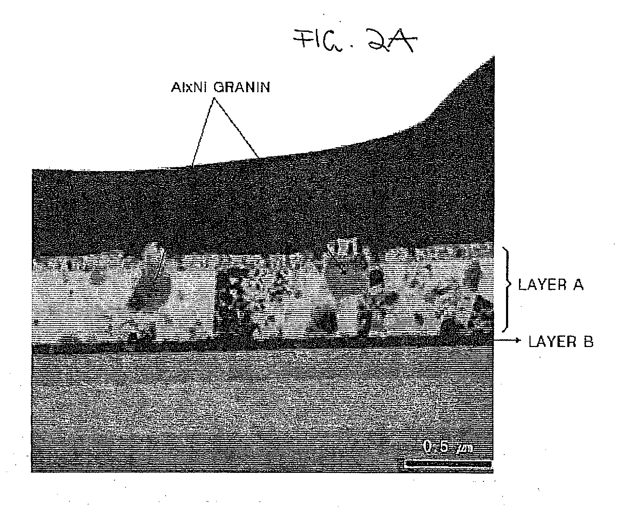

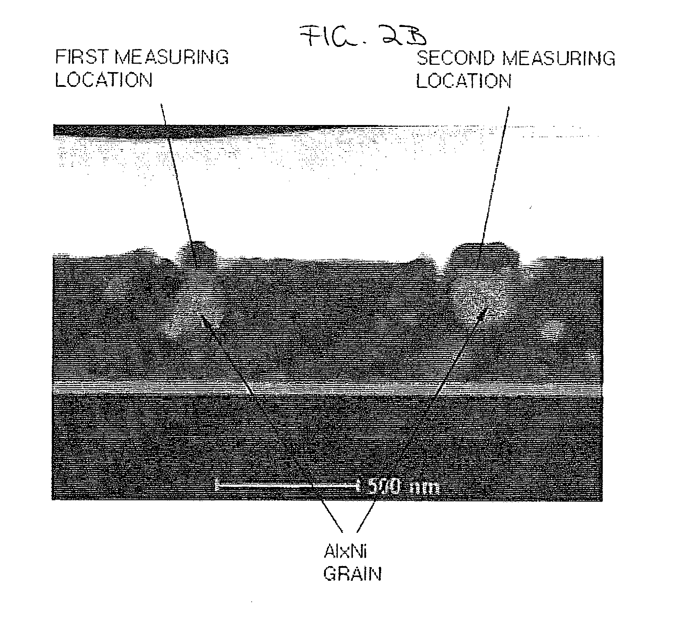

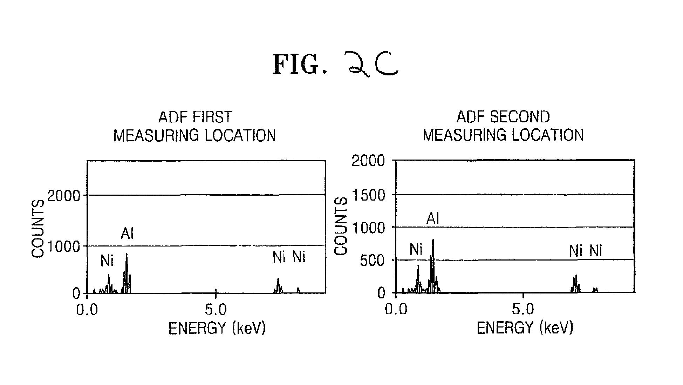

FIG. 2A is a cross-sectional transmission electron microscope (TEM) image of an Al-based reflective film (layer A) including about 2 weight % of Ni and about 0.35 weight % of La, formed on a Ti layer (layer B), FIG. 2Ba shows a scanning transmission electron microscope (STEM) high-angle annular dark-filed (HAADF) image of the aluminum (Al)-based reflective film and FIG. 2C shows graphs showing a result of analyzing abnormal grown grains (a first measuring location and a second measuring location) observed as grey circular lumps using an energy dispersive spectrometer (EDS) semi-quantitative analysis. Accordingly, since Al and Ni exist in the abnormal grown grains of FIG. 2A with a ratio of about Al(K):Ni(K)=73:27 (based on atom %), the Al-based reflective film may include a material presumed to be Al₃Ni.

As shown, the intermetallic Al₃Ni phase contacts the transparent conductive film.

Also, a Ni rich oxide layer exists on the surface of the Al-based reflective film 5a which faces the transparent conductive film 5b. The Ni rich oxide layer exists between the Al-based reflective film 5a and the transparent conductive film 5b in FIG. 1.

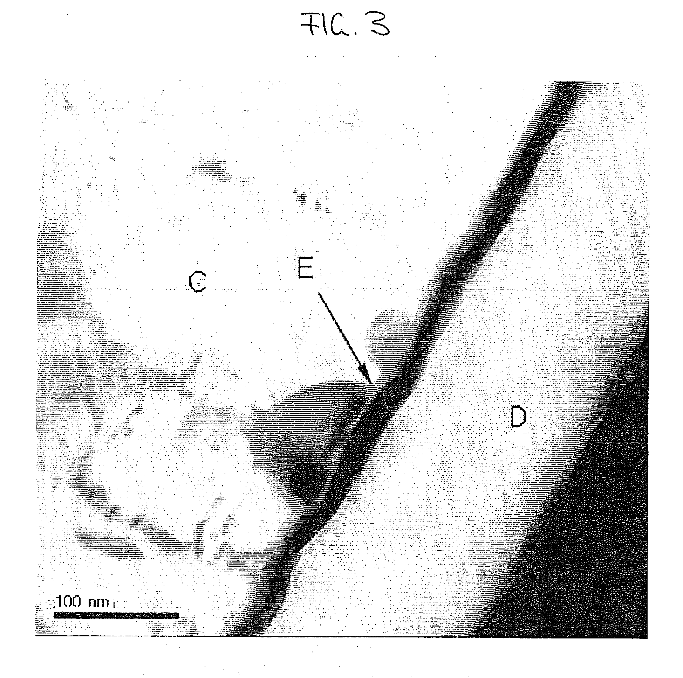

FIG. 3 is a cross-sectional TEM image of a structure formed of an Al-based reflective film and an ITO transparent conductive film. The Al-based reflective film C, includes about 2 weight % of Ni and about 0.35 weight % of La, and is formed on a general TFT substrate. The ITO transparent conductive film D is formed on the Al-based reflective film. In FIG. 3, a part of a white line (refer to a line represented by E), which is represented as an oblique line and formed between the Al-based reflective film and the ITO conductive film, is the Ni rich oxide layer. The thickness of the Ni rich oxide layer may be in the range of about 7 nm to about 8 nm.

An ohmic contact may be formed between the Al-based reflective film 5a and the transparent conductive film 5b due to the AlₓNi phase (here, x represents atom % of Al and may be in the range of about 2.5 to about 3.5) and/or the Ni rich oxide layer described above.

The amount of Ni in the Al-based reflective film 5a may be in the range of 0.6 weight % to 5 weight %, preferably 1 weight % to 4 weight %. The amount of Ni in the OLED according to the present embodiment may be for example about 2 weight %. When the amount of Ni in the Al-based reflective film 5a is 0.6 weight % or more, contact resistance stability between the Al-based reflective film 5a and the transparent conductive film 5b is excellent. When the amount of Ni in the Al-based reflective film 5a is 5 weight % or less, reflectivity and chemical resistance of the Al-based reflective film 5a is not substantially decreased.

The Al-based reflective film 5a further includes the rare earth metal, in addition to Ni. The rare earth metal is at least one of La, Ce, Pr, Pm, Sm, Eu, Gd, Tb, Dy, Ho, Er, Tm, and Lu.

As the Al-based reflective film 5a includes the rare earth metal described above, thermal stability is improved and galvanic corrosion can be suppressed. Preferably, the rare earth metal is La.

The (total) amount of the rare earth metal may be in the range of 0.1 to 3 weight %, preferably 0.1 weight % to 1 weight %. When the amount of the rare earth metal is 0.1 weight % or more, thermal stability of Al in the Al-based reflective film 5a is not substantially decreased. When the amount of the rare earth metal is 3 weight % or less, decrease in reflectivity is substantially prevented.

The thickness of the Al-based reflective film 5a may be 50 nm or above, preferably in the range of 100 nm to 500 nm. When the thickness of the Al-based reflective film 5a is 50 nm or above, light generated from the organic layer 7 penetrates the Al-based reflective film 5a and thus decrease in light efficiency is substantially prevented.

The transparent conductive film 5b may be a transparent and conductive metal oxide. Preferred examples of the transparent conductive film 5b may include indium tin oxide (ITO), indium zinc oxide (IZO), tin oxide (SnO₂), or zinc oxide (ZnO).

The thickness of the transparent conductive film 5b may be in the range of 5 nm to 100 nm, preferably 7 nm to 80 nm. When the thickness of the transparent conductive film 5b is in the above range, decrease in reflectivity of the Al-based reflective film 5a can be minimized and the first electrode having a high efficiency can be realized.

The organic layer 7 is formed on the transparent conductive film 5b. In this specification, the "organic layer" denotes all layers interposed between a first electrode and a second electrode. Thus, the organic layer is not always formed only of pure organic material but may include also metal-organic complexes.

The organic layer 7 includes an emitting layer (EML). The organic layer 7 may further include a hole injection layer (HIL), a hole transfer layer (HTL), a hole blocking layer (HBL), an electron transfer layer (ETL), an electron injection layer (EIL), or combinations thereof.

The HIL may be formed on the first electrode 5 by using a method such as vacuum deposition, spin coating, casting, or Langmuir-Blodgett (LB) deposition.

If the HIL is formed using vacuum deposition, the deposition conditions may vary according to a compound used as a material for forming the HIL, and a structure and thermal characteristics of the HIL. For example, the deposition temperature may be in the range of about 100 to about 500 °C, the degree of vacuum may be in the range of about 10⁻⁸ to about 10-³ torr, and deposition speed may be in the range of about 0.01 to about 100 Å/sec.

If the HIL is formed using spin coating, the coating conditions may vary according to a compound used as a material for forming the HIL, and a structure and thermal characteristics of the HIL. Coating speed may be in the range of about 2000 rpm to about 5000 rpm and a heat-treatment temperature for removing a solvent after coating may be in the range of about 80 °C to about 200 °C.

The material for forming the HIL may be a well-known hole injection material. Examples of the material may include a phthalocyanine compound such as copper phthalocyanines, m-MTDATA [4,4',4"-tris(3-methylphenylphenylamino)triphenylamine], NPB (N,N'-di(1-naphthyl)-N,N'-diphenylbenzidine(N,N'-di(1-naphthyl)-N,N'-diphenylbenzidine)), TDATA, 2T-NATA, Pani/DBSA (polyaniline/dodecylbenzenesulfonic acid), PEDOT/PSS (poly(3,4-ethylenedioxythiophene)/poly(4-styrenesulfonate), Pani/CSA (polyaniline/camphor sulfonic acid), or PANI/PSS (polyaniline)/poly(4-styrenesulfonate).

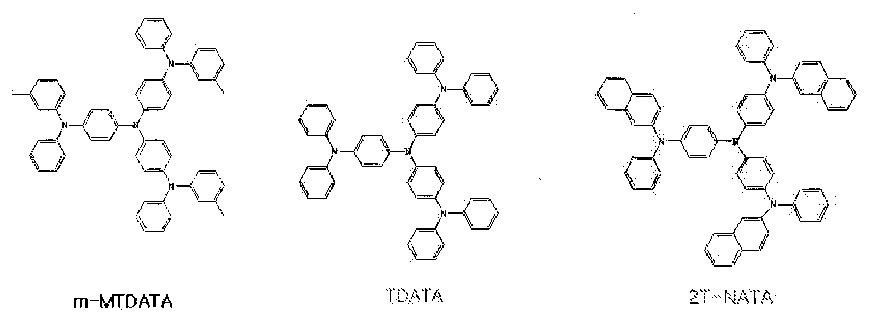

The thickness of the HIL may be in the range of about 100 Å to about 10000 Å, for example, about 100 Å to about 1000 Å. When the thickness of the HIL is in the above range, satisfactory hole injecting characteristics may be obtained without an increase in a driving voltage of the OLED.

Then, the hole transfer layer (HTL) may be formed on the hole injection layer (HIL) by using a method such as vacuum deposition, spin coating, casting, or LB deposition. If the HTL is formed using vacuum deposition or spin coating, deposition or coating conditions may vary according to compounds used. However, in general, the conditions may be similar to those used to form the HIL.

The material for forming the HTL may be a well-known hole transfer material. Examples of the material may include a carbazol derivative such as N-phenylcarbazol, polyvinyl carbazole, an amine derivative having an aromatic fused ring such as N,N'-bis(3-methylphenyl)-N,N'-diphenyl-[1,1-biphenyl]-4,4'-diamine (TPD) and N,N'-di(naphthalen-1-yl)-N,N'-diphenyl benzidine (α-NPD), and a triphenylamine-based material such as 4,4',4"-tris(N-carbazolyl)triphenylamine) (TCTA). Here, TCTA may prevent dispersion of the excitons from the EML, in addition to the function of transferring holes.

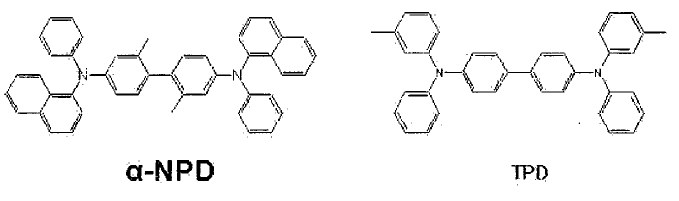

The thickness of the HTL may be in the range of about 50 Å to about 1000 Å, for example, about 100 Å to about 800 Å. When the thickness of the HTL is in the above range, satisfactory hole transferring characteristics may be obtained without an increase in the driving voltage of the OLED.

The emitting layer (EML) may be formed on the hole transfer layer (HTL) by using a method such as vacuum deposition, spin coating, casting, or LB deposition. When the EML is formed using vacuum deposition or spin coating, the deposition or coating conditions may vary according to compounds used. However, in general, the conditions may be similar to those used to form the hole injection layer (HIL).

The EML may include one compound or a combination of a host and a dopant. Examples of the host may include Alq₃, 4,4'-N,N'-dicabazole-biphenyl (CBP), poly(n-vinylcarbazole (PVK), 9,10-di(naphthalen-2-yl)anthracene (ADN), TCTA, 1,3,5-tris(N-phenylbenzimidazole-2-yl)benzene (TPBI), 3-tert-butyl-9,10-di(napth-2-yl)anthracene (TBADN), E3, distyrylarylene (DSA).

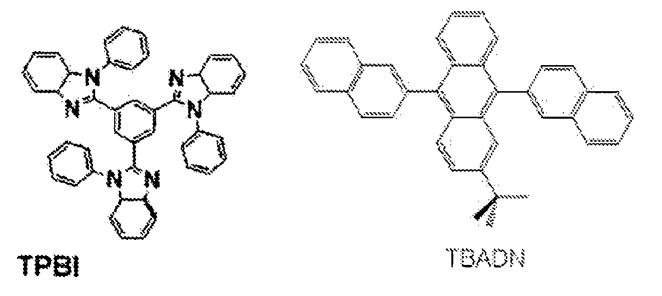

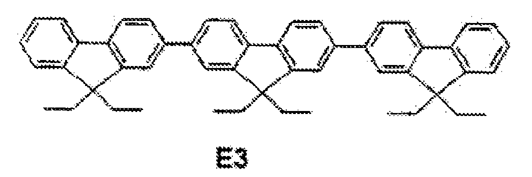

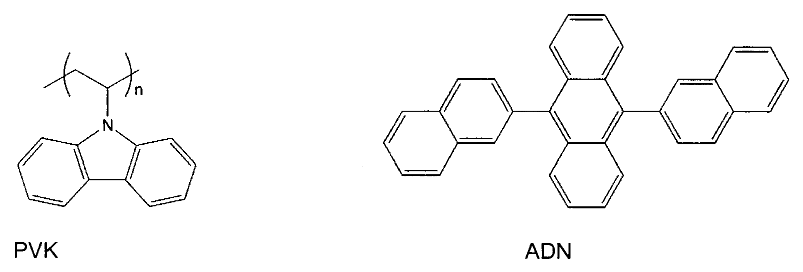

A red dopant may be a well-known red dopant such as PtOEP, Ir(piq)₃, Btp₂lr(acac), or DCJTB. However, the red dopant is not limited thereto.

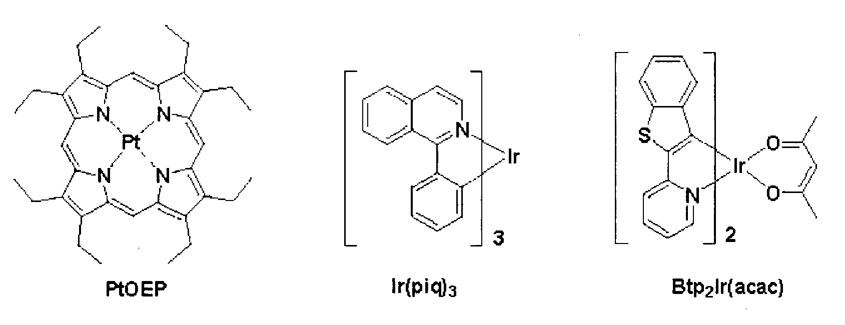

A green dopant may be a well-known green dopant such as Ir(ppy)₃ (ppy is phenyl pyridine), Ir(ppy)₂(acac), Ir(mpyp)₃, or C545T.

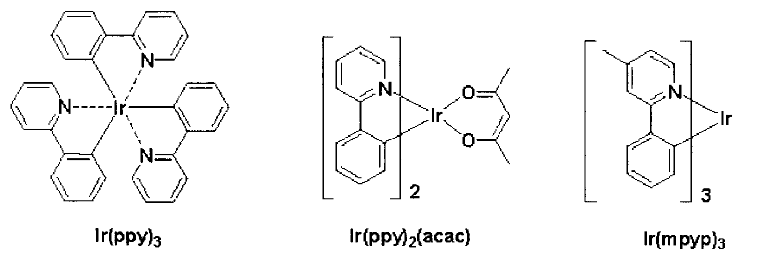

A blue dopant may be a well-known blue dopant such as F₂lrpic, (F₂ppy)₂lr(tmd), Ir(dfppz)₃, ter-fluorene, 4,4'-bis(4-diphenylaminostyryl) biphenyl (DPAVBi), or 2,5,8,11-tetra-t-butylperylene (TBPe).

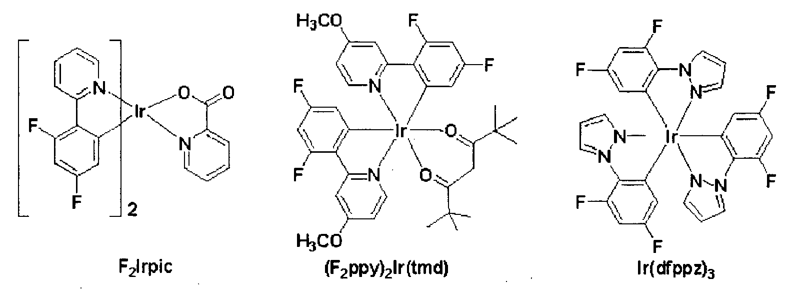

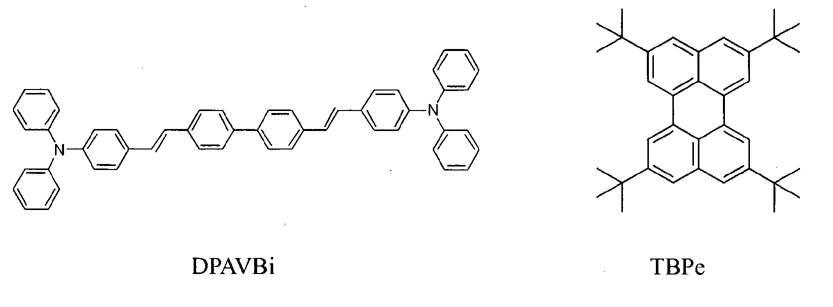

When the dopant and the host are used together, the doping concentration of the dopant is not limited. However, in general, the amount of dopant may be in the range of about 0.01 parts by weight to about 15 parts by weight based on 100 parts by weight of the host.

The thickness of the emitting layer (EML) may be in the range of about 100 Å to about 1000 Å, for example, about 200 Å to about 600 Å. When the thickness of the EML is in the above range, excellent emitting characteristics may be obtained without an increase in the driving voltage of the OLED.

When a phosphorescent dopant is used in the EML, the hole blocking layer (HBL) may be formed between the hole transfer layer (HTL) and the EML by using a method such as vacuum deposition, spin coating, casting, or LB deposition in order to prevent dispersion of triplet excitons or holes to the HTL. When the HBL is formed using vacuum deposition or spin coating, the deposition or coating conditions thereof may vary according to compounds used. However, in general, the conditions may be similar to those used to form the hole injection layer (HIL). A material for forming the HBL may be a well-known hole blocking material. Examples of the material may include an oxadiazole derivative, a triazole derivative, and a phenanthroline derivative.

The thickness of the HBL may be in the range of about 500 Å to about 1000 Å, for example, about 100 Å to about 300 Å. When the thickness of the HBL is in the above range, excellent hole blocking characteristics may be obtained without an increase in the driving voltage of the OLED.

Then, the electron transfer layer (ETL) may be formed on the EML or the HBL using a method such as vacuum deposition, spin coating, or casting. When the ETL is formed using vacuum deposition or spin coating, the deposition or coating conditions thereof may vary according to compounds used. However, in general, the conditions may be similar to those used to form the HIL. A material for forming the ETL may stably transfer electrons injected from an electron injection electrode (cathode) and may include an electron transfer material. Examples of the material may include a quinoline derivative, for examples, tris(8-quinolinolate)aluminum (Alq3), TAZ, and Balq.

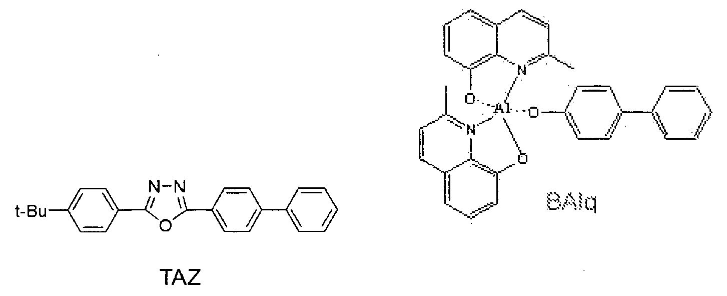

The thickness of the ETL may be in the range of about 100 Å to about 1000 Å, for example, about 150 Å to about 500 Å. When the thickness of the ETL is in the above range, satisfactory electron transfer characteristics may be obtained without a decrease in the driving voltage of the OLED.

In addition, the electron injection layer (EIL) for facilitating injection of electrons from the cathode may be formed on the ETL and a material for forming the EIL is not limited.

The material for forming the EIL may be any material used as an electron injection material such as LiF, NaCl, CsF, Li₂O, or BaO. The EIL may be formed using a method such as vacuum deposition, spin coating, casting, or Langmuir-Blodgett (LB) deposition. The deposition or coating conditions may vary according to a compound used. However, in general, the conditions may be similar to those used to form the HIL.

The thickness of the EIL may be in the range of about 1 Å to about 100 Å, for example, about 5 Å to about 90 Å. When the thickness of the EIL is in the above range, excellent electron injection characteristics may be obtained without an increase in the driving voltage of the OLED.

The second electrode 9, which is a transmissive electrode, is formed on the organic layer 7. The second electrode 9 may be the electron injection electrode, that is, the cathode. A material for forming the second electrode 9 may include a metal having a low work function, an alloy, an electrically conductive compound, or a mixture thereof. Examples of the material for forming the second electrode 9 may include a thin film formed of lithium (Li), magnesium (Mg), aluminum (Al), aluminum-lithium (Al-Li), calcium (Ca), magnesium-indium (Mg-In), or magnesium-silver (Mg-Ag). In addition, in order to obtain a top emission device, the transmissive electrode may be formed using ITO or IZO.

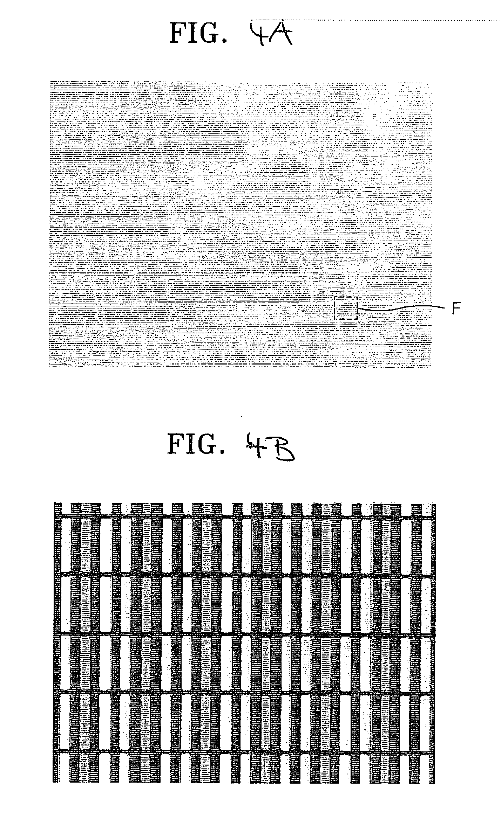

FIG. 4A is a photographic image of an OLED observed with the naked eye and FIG. 4B is a microscopic image of a part of the image of FIG. 4A. Referring to FIG. 4A, an Al-based reflective film having a thickness of about 125 nm and including Ni and La (the amount of Ni is about 2 weight % and the amount of La is about 0.35 weight %), and an ITO transparent conductive film having a thickness of about 70 nm are sequentially formed on a TFT substrate. The Al-based reflective film and the ITO transparent conductive film together constitute a first electrode. Then, a general organic layer and a transparent cathode are sequentially formed on the ITO transparent conductive film so as to form an OLED and the OLED is driven and observed with the naked eye. In FIG. 4B, a part marked by a dashed rectangle F in the image of FIG. 4A is observed using a microscope.

FIGS. 4A and 4B show that the OLED including the first electrode constituted as described above may provide uniform brightness and clear images.

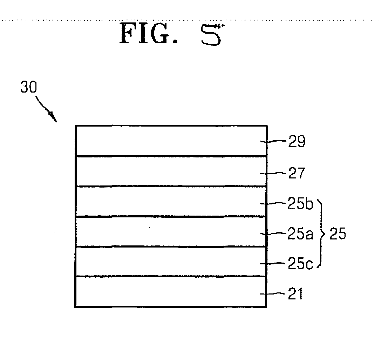

FIG. 5 is a cross-sectional diagram of an OLED 20 according to another embodiment of the present invention. Referring to FIG. 5, the OLED 20 according to the present embodiment includes a substrate 21, a first electrode 25, an organic layer 27, and a second electrode 29. The first electrode 25 includes a metal layer 25c, an Al-based reflective film 25a including Ni and a first element, and a transparent conductive film 25b sequentially formed on the substrate 21 in this order. Here, the substrate 21, the organic layer 27, the second electrode 29, the Al-based reflective film 25a including Ni and a first element, and the transparent conductive film 25b are similar to those of the embodiment described referring to FIG. 1.

Referring to FIG. 5, the first electrode 25 in the OLED 20 further includes the metal layer 25c. The metal layer 25c may be interposed between the Al-based reflective film 25a, including Ni and a first element, and the substrate 21. For example, the metal layer 25c may be formed on a surface of the Al-based reflective film 25a which does not contact the transparent conductive film 25b.

The metal layer 25c may be a barrier layer for dispersion of Al components in the Al-based reflective film 25a included in the first electrode 25.

The metal layer 25c may include a metal such as molybdenum (Mo), tungsten (W), titanium (Ti), palladium (Pd), platinum (Pt), gold (Au), or combination thereof. For example, the Al-based reflective film in FIG. 2A may be formed on a Ti layer.

The thickness of the metal layer 25c may be in the range of about 20 nm to about 200 nm, for example, about 50 nm to about 100 nm. When the thickness of the metal layer 25c is in the above range, dispersion of the Al components may be prevented.

As described above, according to the one or more of the above embodiments of the present invention, an OLED including a first electrode as described above has excellent thermal stability, light efficiency, and durability.

## Claims

1. An organic light emitting diode (OLED) comprising:
a substrate (1);
a first electrode (5) formed on the substrate (1);
a second electrode (9) disposed on the first electrode (5); and
an organic layer (7) interposed between the first electrode (5) and the second electrode (9), wherein the first electrode (5) comprises:
an aluminum (Al)-based reflective film (5a) comprising nickel (Ni) and at least one rare earth metal selected from the group consisting of lanthanum (La), cerium (Ce), praseodymium (Pr), promethium (Pm), samarium (Sm), europium (Eu), gadolinium (Gd), terbium (Tb), dysprosium (Dy), holmium (Ho), erbium (Er), thulium (Tm) and lutetium (Lu); and
a transparent conductive film (5b) interposed between the Al-based reflective film (5a) and the organic layer (7); and
**characterized in that** the first electrode (5) further comprises a Ni rich oxide layer interposed between the Al-based reflective film (5a) and the transparent conductive film (5b).

2. The OLED of claim 1, wherein the Al-based reflective film (5a) comprises grains of an intermetallic phase consisting of AlₓNi, where x is in the range of 2.5 to 3.5.

3. The OLED of claim 2, wherein the grains contact the transparent conductive film (5b).

4. The OLED of claim 2 or 3, wherein intermetallic phase consists of Al₃Ni.

5. The OLED of any one of the preceding claims, wherein the amount of Ni in the Al-based reflective film (5a) is in a range of 0.6 weight % to 5 weight %.

6. The OLED of any one of the preceding claims, wherein the rare earth metal is lanthanum (La).

7. The OLED of any one of the preceding claims, wherein the amount of the rare earth metal is 0.1 weight % to 3 weight %.

8. The OLED of any one of the preceding claims, wherein the thickness of the Al-based reflective film (5a) is 50 nm or greater.

9. The OLED of any one of the preceding claims, wherein the transparent conductive film (5b) is one selected from the group consisting of indium tin oxide (ITO), indium zinc oxide (IZO), tin oxide (SnO₂), and zinc oxide (ZnO).

10. The OLED of any one of the preceding claims, wherein the thickness of the transparent conductive film (5b) is in the range of 5 nm to 100 nm.

11. The OLED of any one of the preceding claims, wherein the first electrode (5) further comprises a metal layer, the metal layer being formed between the Al-based reflective film (5a) and the substrate (1).

12. The OLED of claim 11, wherein the metal layer comprises at least one metal selected from the group consisting of molybdenum (Mo), tungsten (W), titanium (Ti), palladium (Pd), platinum (Pt), and gold (Au).

13. The OLED of any one of the preceding claims, wherein the organic layer (7) comprises an emitting layer (EML) and optionally at least one selected from the group consisting of a hole injection layer (HIL), a hole transfer layer (HTL), a hole blocking layer (HBL), an electron transfer layer (ETL), and an electron injection layer (EIL).

## Patentansprüche

1. Organische lichtemittierende Diode (OLED), aufweisend:
ein Substrat (1);
eine erste Elektrode (5), die auf dem Substrat (1) ausgebildet ist;
eine zweite Elektrode (9), die auf der ersten Elektrode (5) angeordnet ist; und
eine organische Schicht (7), die zwischen die erste Elektrode (5) und die zweite Elektrode (9) eingefügt ist, wobei die erste Elektrode (5) aufweist:
einen reflektierenden Film (5a) auf der Basis von Aluminium (Al), der Nickel (Ni) und zumindest ein Metall der Seltenen Erden aufweist, das aus der Gruppe bestehend aus Lanthan (La), Cer (Ce), Praseodym (Pr), Promethium (Pm), Samarium (Sm), Europium (Eu), Gadolinium (Gd), Terbium (Tb), Dysprosium (Dy), Holmium (Ho), Erbium (Er), Thulium (Tm) und Lutetium (Lu) ausgewählt ist; und
einen transparenten leitenden Film (5b), der zwischen den reflektierenden Film (5a) auf Al-Basis und die organische Schicht (7) eingefügt ist; und
**dadurch gekennzeichnet, dass** die erste Elektrode (5) weiterhin eine Nireiche Oxidschicht aufweist, die zwischen den reflektierenden Film (5a) auf Al-Basis und den transparenten leitenden Film (5b) eingefügt ist.

2. OLED nach Anspruch 1, wobei der reflektierende Film (5a) auf Al-Basis Körner einer intermetallischen Phase bestehend aus AlₓNi aufweist, wobei x im Bereich von 2,5 bis 3,5 liegt.

3. OLED nach Anspruch 2, wobei die Körner mit dem transparenten leitenden Film (5b) in Kontakt stehen.

4. OLED nach Anspruch 2 oder 3, wobei die intermetallische Phase aus Al₃Ni besteht.

5. OLED nach einem der vorhergehenden Ansprüche, wobei die Menge von Ni im reflektierenden Film (5a) auf Al-Basis in einem Bereich von 0,6 Ges.-% bis 5 Gew.-% liegt.

6. OLED nach einem der vorhergehenden Ansprüche, wobei das Metall der Seltenen Erden Lanthan (La) ist.

7. OLED nach einem der vorhergehenden Ansprüche, wobei die Menge des Metalls der Seltenen Erden 0,1 Gew.-% bis 3 Gew.-% beträgt.

8. OLED nach einem der vorhergehenden Ansprüche, wobei die Dicke des reflektierenden Films (5a) auf Al-Basis 50nm oder mehr beträgt.

9. OLED nach einem der vorhergehenden Ansprüche, wobei der transparente leitende Film (5b) ein Film ist, der aus der Gruppe bestehend aus Indiumzinnoxid (ITO), Indiumzinkoxid (IZO), Zinnoxid (SnO₂) und Zinkoxid (ZnO) ausgewählt ist.

10. OLED nach einem der vorhergehenden Ansprüche, wobei die Dicke des transparenten leitenden Films (5b) im Bereich von 5nm bis 100nm liegt.

11. OLED nach einem der vorhergehenden Ansprüche, wobei die erste Elektrode (5) weiterhin eine Metallschicht aufweist, wobei die Metallschicht zwischen dem reflektierenden Film (5a) auf Al-Basis und dem Substrat (1) ausgebildet ist.

12. OLED nach Anspruch 11, wobei die Metallschicht zumindest ein Metall aufweist, das aus der Gruppe bestehend aus Molybdän (Mo), Wolfram (W), Titan (Ti), Palladium (Pd), Platin (Pt) und Gold (Au) ausgewählt ist.

13. OLED nach einem der vorhergehenden Ansprüche, wobei die organische Schicht (7) eine emittierende Schicht (EML) und wahlweise zumindest eine Schicht aufweist, die aus der Gruppe bestehend aus einer Lochinjektionsschicht (HIL), einer Lochtransferschicht (HTL), einer Lochblockierschicht (HBL), einer Elektronentransferschicht (ETL) und einer Elektroneninjektionsschicht (EIL) ausgewählt ist.

## Revendications

1. Diode électroluminescente organique (OLED pour « Organic Light Emitting Diode ») comprenant :
un substrat (1) ;
une première électrode (5) formée sur le substrat (1) ;
une deuxième électrode (9) disposée sur la première électrode (5) ; et
une couche organique (7) interposée entre la première électrode (5) et la deuxième électrode (9), la première électrode (5) comprenant :
un film réfléchissant à base d'aluminium (Al) (5a) comprenant du Nickel (Ni) et au moins un métal des terres rares choisi dans le groupe constitué du lanthane (La), du cérium (Ce), du praséodyme (Pr), du prométhium (Pm), du samarium (Sm), de l'europium (Eu), du gadolinium (Gd), du terbium (Tb), du dysprosium (Dy), de l'holmium (Ho), de l'erbium (Er), du thulium (Tm), et du lutétium (Lu) ; et
un film conducteur transparent (5b) interposé entre le film réfléchissant à base d'Al (5a) et la couche organique (7) ; et
**caractérisée en ce que** la première électrode (5) comprend en outre une couche d'oxyde riche en Ni interposée entre le film réfléchissant à base d'Al (5a) et le film conducteur transparent (5b).

2. Diode OLED de la revendication 1, dans laquelle le film réfléchissant à base d'Al (5a) comprend des grains d'une phase intermétallique constituée de AlₓNi, où x se situe dans la plage allant de 2,5 à 3,5.

3. Diode OLED de la revendication 2, dans laquelle les grains entrent en contact avec le film conducteur transparent (5b).

4. Diode OLED de la revendication 2 ou 3, dans laquelle la phase intermétallique est constituée de Al₃Ni.

5. Diode OLED de l'une quelconque des revendications précédentes, dans laquelle la quantité de Ni dans le film réfléchissant à base d'Al (5a) se situe dans une plage allant de 0,6 % en poids à 5 % en poids.

6. Diode OLED de l'une quelconque des revendications précédentes, dans laquelle le métal des terres rares est le lanthane (La).

7. Diode OLED de l'une quelconque des revendications précédentes, dans laquelle la quantité du métal des terres rares est de 0,1 % en poids à 3 % en poids.

8. Diode OLED de l'une quelconque des revendications précédentes, dans laquelle l'épaisseur du film réfléchissant à base d'Al (5a) est supérieure ou égale à 50 nm.

9. Diode OLED de l'une quelconque des revendications précédentes, dans laquelle le film conducteur transparent (5b) est un élément choisi dans le groupe constitué d'oxyde d'étain-indium (ITO), oxyde de zinc-indium (IZO), oxyde d'étain (SnO₂), et d'oxyde de zinc (ZnO).

10. Diode OLED de l'une quelconque des revendications précédentes, dans laquelle l'épaisseur du film conducteur transparent (5b) se situe dans la plage allant de 5 nm à 100 nm.

11. Diode OLED de l'une quelconque des revendications précédentes, dans laquelle la première électrode (5) comprend en outre une couche de métal, la couche de métal étant formée entre le film réfléchissant à base d'Al (5a) et le substrat (1).

12. Diode OLED de la revendication 11, dans laquelle la couche de métal comprend au moins un métal choisi dans le groupe constitué du molybdène (Mo), du tungstène (W), du titane (Ti), du palladium (Pd), du platine (Pt) et de l'or (Au).

13. Diode OLED de l'une quelconque des revendications précédentes, dans laquelle la couche organique (7) comprend une couche émettrice (EML) et éventuellement au moins un élément choisi dans le groupe constitué d'une couche d'injection de trous (HIL), d'une couche de transport de trous (HTL), d'une couche de blocage de trous (HBL), d'une couche de transport d'électrons (ETL), et d'une couche d'injection d'électrons (EIL).
